# EUROPÄISCHE PATENTSCHRIFT

(11) **EP 0 937 317 B1**
(45) Veröffentlichungstag und Bekanntmachung des Hinweises auf die Patenterteilung: **16.08.2000**
(21) Anmeldenummer: 97948731.1
(22) Anmeldetag: 07.11.1997
(51) Int. Cl.: H01R 4/64, H05K 7/14, H05K 9/00

(54) **BAUGRUPPENTRÄGER FÜR LEITERPLATTEN MIT MITTELQUERSCHIENEN**
SUB-RACK FOR CIRCUIT BOARDS WITH CENTRAL CROSS-TRACKS
BATI ELECTRONIQUE POUR CARTES DE CIRCUITS AVEC RAILS TRANSVERSAUX CENTRAUX

(30) Priorität: 11.11.1996 DE 29619475 U
(43) Veröffentlichungstag der Anmeldung: 25.08.1999
(73) Patentinhaber: SIEMENS AKTIENGESELLSCHAFT, 80333 München (DE)
(72) Erfinder: KURRER, Siegfried, D-90449 Nürnberg (DE); BILLENSTEIN, Ernst, D-91593 Burgbernheim (DE); SCHAFFER, Kurt-Michael, D-90542 Eckental (DE)
(86) Internationale Anmeldenummer: DE9702596
(87) Internationale Veröffentlichungsnummer: WO9821782

(56) Entgegenhaltungen:
- EP-A- 0 264 686
- DE-C- 4 110 872
- DE-C- 4 205 893
- DE-C- 4 210 466
- US-A- 4 669 616
- US-A- 5 022 863
- US-A- 5 313 370

## Beschreibung

Im Grundaufbau enthält ein Baugruppenträger für elektrische Leiterplatten in aller Regel zwei Seitenwandbleche, welche durch Querschienen miteinander verbunden sind. Dabei wird die Front- und die Rückseite des Baugruppenträgers durch je ein Paar von oberen und unteren Querschienen gebildet. In diese Querschienen werden zur Bildung von sogenannten Einbauplätzen gegenüberliegend Paare von Führungsschienen eingerastet, in die Leiterplatten senkrecht stehend parallel nebeneinander eingeschoben werden können. Durch die Kantenlänge der in den Baugruppenträger einzuschiebenden Leiterplatten wird der vertikale Abstand der Querschienen an Front- und Rückseite des Baugruppenträgers, und damit dessen Gesamthöhe bestimmt.

In der Praxis stehen Leiterplatten mit unterschiedlichen Kantenlängen zur Verfügung, welche üblicherweise als Leiterplatten mit einfacher oder zweifacher Bauhöhe ("Europaformat") bezeichnet werden. Bei manchen Anwendungen ist es notwendig, in einem sogenannten Mischaufbau, sowohl Leiterplatten mit einfacher als auch zweifacher Bauhöhe in einem einzigen Baugruppenträger unterzubringen. Hierzu werden zumindest über einen Teilbereich der Front- und Rückseite eines Baugruppenträgers zwischen die üblichen oberen und unteren Querschienen zumindest zwei rückseitig aufeinander liegende, in der Regel horizontale Mittelquerschienen eingezogen, und z.B. an einer zusätzlichen vertikalen Mitteltrennwand befestigt. Auf der einen Seite der Mitteltrennwand steht dann die volle Bauhöhe des Baugruppenträgers zur Verfügung, und es können Leiterplatten mit z.B. doppelter Kantenlängen in die an der oberen und unteren Querschiene angebrachten Führungsschienen eingeschoben werden.

Auf der anderen Seite der Mitteltrennwand ist die gesamt Bauhöhe des Baugruppenträgers durch das Paar der horizontalen Mittelquerschienen geteilt. Es entstehen dann zwei übereinander liegende Bereiche, in welche Leiterplatten mit z.B. einfacher Kantenlänge eingeschoben werden können. So können derartige Leiterplatten zum einen in die Paare von gegenüber liegenden Führungsschienen eingeschoben werden, welche in der oberen Querschiene des Baugruppenträgers und der oberen der beiden Mittelquerschienen eingerastet sind, und zum anderen Leiterplatten in die Paare von gegenüber liegenden Führungsschienen eingeschoben werden, welche in der unteren der beiden Mittelquerschienen und der unteren Querschiene des Baugruppenträgers eingerastet sind.

Derartige Anordnungen sind z.B. in SIEMENS, SIPAC, Aufbausystem metrisch, Katalog ET 2, November 1990, auf der Seite 6/19 dargestellt.

Ferner weisen Leiterplatten in der Regel eine aus einem elektrisch leitenden Material bestehende Frontplatte auf. Die Frontplatten von nebeneinander liegend in einen Baugruppenträger eingeschobenen Leiterplatten sind über Kontaktfederleisten untereinander leitend verbunden und bilden somit eine abschirmende Abdeckung des Baugruppenträgers und der darin befindlichen Leiterplatten. Ferner ist jede Leiterplatte z.B. in der unteren und oberen Stirnseite z.B. über eine Halteschraube elektrisch leitend mit der unteren und oberen Querschiene oder unteren und oberen Mittelquerschiene verbunden. Zur elektromagnetischen Abdichtung sind in der Regel an weiteren Stellen des Baugruppenträgers Kontaktmittel vorgesehen. So sind z.B. sogenannte Etagenschirmbleche, welche einen Baugruppenträger auf der Ober- und Unterseite abdecken, über speziell ausgebildete Kontaktfederstreifen mit den vorderen und hinteren Querschienen sowohl an der oberen und als auch unteren Seite des Baugruppenträgers befestigt.

Ein besonderes Problem besteht nun darin, den in aller Regel vorhandenen Spalt zwischen zwei rückseitig aufeinander liegenden horizontalen Mittelquerschienen elektromagnetisch dicht abzuschließen. Da dieser Spalt durch die Kanten der Frontplatten von Leiterplatten, welche in die Bereiche oberhalb und unterhalb der Mittelquerschienen eingeschoben sind, nicht abgedeckt wird, können zur sogenannten Frontplattenabdichtung vorgesehene, sogenannte Kontaktstreifen in den Spalt zwischen den beiden rückseitig aufeinander liegenden Mittelquerschienen eingelegt oder eingeklebt werden. Eine entsprechende Anordnung von zwei rückseitig aufeinander liegenden Querverbindungsschienen ist z.B. in RITTAL, Ripac your elektronics with Perfection ..., Katalog Seite 55 dargestellt. In den Spalt zwischen den beiden Querverbindungsschienen ist "EMC gasket" genannter Kontaktstreifen eingeleg. Diese Kontaktstreifen können aus einem Metallstreifen bestehen, an dessen einer Längskante eine Vielzahl von Kontaktzähnen schräg abgebogen sind. Ein derartiger, aufklebbarer Kontaktstreifen mit abgebogenen Kontaktzähnen ist z.B. im GESAMTKATALOG Bavaria Elektronik, RFI-EMI-EMP Abschirmtechnik, 1994, auf den dortigen Seiten 45 und 46 dargestellt. Beim unterer Teil Einsatz derartiger Kontaktstreifen im Spalt zwischen zwei Mittelquerschienen kann aber das Problem auftreten, daß die von den Kontaktzähnen aufgebrachten Federkräfte eine konkave Aufbiegung des Spaltes insbesondere im Bereich von dessen Mitte hervorrufen. Dies hat wiederum zur Folge, daß die darüber und darunter liegenden und zum Einschub von Leiterplatten mit in der Regel einfacher Kantenlänge vorgesehenen Bereiche verengt werden. Leiterplatten können dann nur noch durch Krafteinwirkung gegen die in den Führungsschienen auf die Kanten der Leiterplatten einwirkenden Klemm- und Reibungskräfte in den Baugruppenträger eingeschoben werden.

Der Erfindung liegt die Aufgabe zugrunde, einen Baugruppenträger so weiterzubilden, daß die elektromagnetische Kontaktierung im Spalt zwischen zwei rückseitig aufeinander liegenden Mittelquerschienen auf einfachere Weise ohne die Gefahr von konkaven Aufbiegungen erfolgt.

Die Aufgabe wird gelöst mit dem im Anspruch 1 angegebenen Baugruppenträger. Weitere, vorteilhafte Ausführungsformen der Erfindung sind in den Unteransprüchen angegeben.

Die Erfindung wird an Hand von in den nachfolgend kurz angeführten Figuren dargestellten Ausführungsbeispielen näher erläutert. Dabei zeigt
- FIG 1 :: eine perspektivische Seitenansicht auf denjenigen Ausschnitt eines Baugruppenträges, welcher zwei aufeinander liegende Mittelquerschienen mit einer beispielhaft eingerasteten Führungsschiene zeigt, und
- FIG 2 :: eine perspektivische Seitenansicht auf eine vorteilhafte Ausführungsform einer Kontaktfederleiste, welche zur elektromagnetisch dichten Kontaktierung in den Spalt von zwei aufeinander liegenden Mittelquerschienen eingreift.

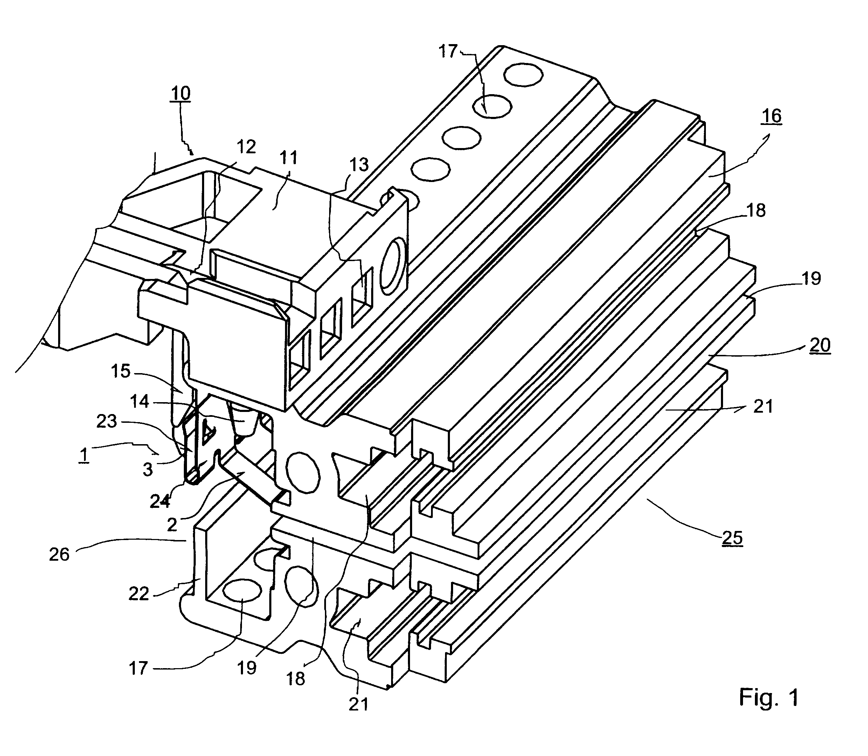

Figur 1 zeigt in einer perspektivischen Seitenansicht einen Baugruppenträger mit mindestens zwei rückseitig aufeinander liegenden horizontalen Mittelquerschienen 16 und 20, welche im Bereich von dessen Frontseite 25 angeordnet sind. Jede der beiden Mittelquerschienen 16, 20 weist eine zur Frontseite 25 geöffnete. quer verlaufende Aufnahmenut 18 bzw. 21 auf. In diese können in üblicher Weise Gewindeschienen eingeschoben werden, in die wiederum Halteschrauben zur Befestigung der Frontplatten von Leiterplatten eingreifen können. Beide Mittelquerschienen 16, 20 weisen auf der jeweiligen Oberseite je eine Reihe von Haltelöchern 17 auf. In diese können Führungsschienen für Leiterplatten eingerastet werden. Im Beispiel der Figur 1 das vordere Endstück 11 einer derartigen Führungsschiene 10 dargestellt. Auf dessen Unterseite stehen Führungsnoppen 14 hervor, welche in die Haltelöcher 17 der oberen Mittelquerschiene 16 eingreifen. Ein dahinter befindlicher Rasthaken 15 hintergreift eine hintere Längskante an der Reihe der Haltlöcher 17, wodurch gemeinsam mit der Führungsnoppe 14 eine feste Halterung der Führungsschiene 10 auf der Mittelquerschiene 16 bewirkt wird. Zur Frontseite 25 des Baugruppenträgers gerichtet sind an der Stirnseite des Endstücks 11 der Führungsschiene 10 im Beispiel der Figur 1 Kodierkammern 13 angeordnet. In diese können entsprechende, an der Unterkante der Frontplatten von Baugruppen angebrachte Kodierstifte eingreifen, so daß ein Belegung von Führungsschienen nur mit zugelassenen Baugruppen bewirkbar ist.

Zur elektromagnetischen Kontaktierung der beiden Mittelquerschienen 16, 20 ist erfindungsgemäß eine Kontaktfederleiste 1 vorhanden, welche auf der von der Front- bzw. Rückseite 25 des Baugruppenträgers abgewandten Innenseite 26 von einer der beiden Mittelquerschienen 16, 20 angebracht ist. Die Kontakfederleiste weist langgestreckte, abgespreizte Kontaktzungen 2 auf, welche bis in den Spalt 19 zwischen den aufeinander liegenden Rücken der beiden Mittelquerschienen 16, 20 reichen und diese miteinander leitend kontaktieren.

Eine derartige Anordnung hat den Vorteil, daß im Spalt zwischen den beiden horizontalen Mittelquerschienen keine durchgängigen, in der Höhe auftragenden Materialien eingelegt sind, und somit keine konkaven Aufwölbungen des Spaltes und somit Verbiegungen der Mittelquerschienen auftreten können. Vielmehr ist der durchgängige Hauptteil der Kontaktfederleiste 1 hinter den beiden Mittelquerschienen und somit außerhalb des Spaltes angebracht. In den Spalt selbst reichen nur die von der Kontaktfederleiste abgespreizten Kontaktzungen, welche auf Grund ihrer Länge eine weiche Federcharakteristik aufweisen. Die Belastung des Spaltes mit Materialien, welche diesen aufbiegen könnten, ist somit sehr gering. Andererseits ist eine nahezu vollständig durchgängige Kontaktierung des Spaltes und somit eine gute elektromagnetische Abdichtung desselben gewährleistet.

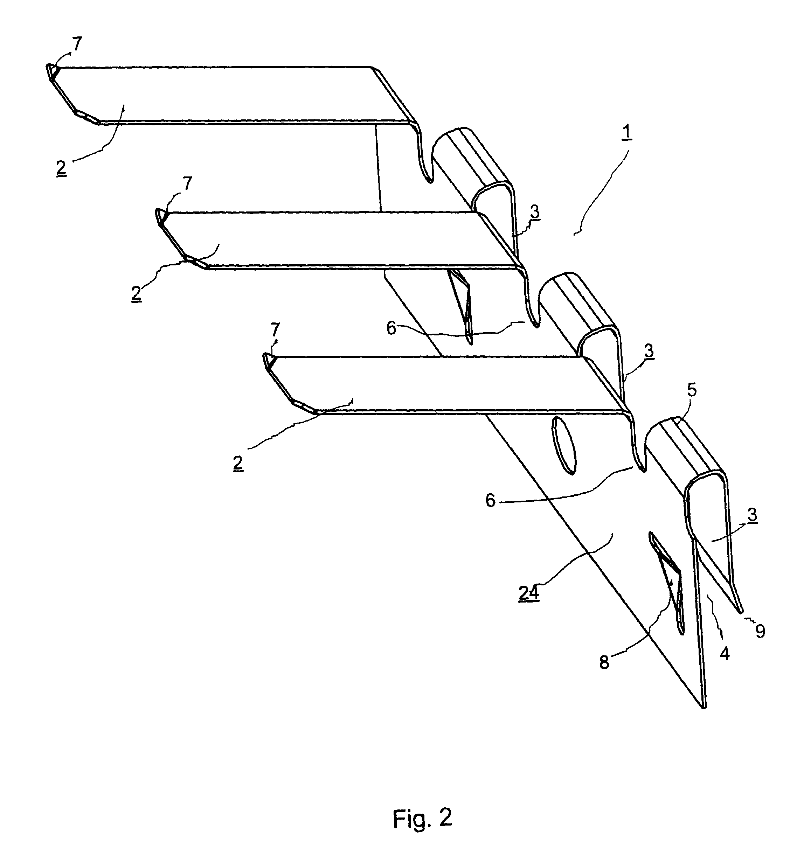

Ein besonders vorteilhafte Ausführung einer bei der Erfindung einsetzbaren Kontaktfederleiste 1 ist in Figur 2 dargestellt. Diese weist eine durchgehende Halteleiste 24 auf, welche eine Haupttragefunktion übernimmt. Von dieser sind zum einen die langgestreckten Kontaktzungen 2 nach einer Seite abgespreizt sind, und zum anderen klammerartige Klemmblätter 3 abgebogen. Vorteilhaft sind die Klemmblätter um einen Kopfbereich 5 herum vollständig abgebogen, so daß diese parallel zur Halteleiste verlaufen. Diese bilden mit der durchgehenden Halteleiste 24 einen Klemmbereich 4. Über diesen Klemmbereich ist die Kontakfederleiste 1 auf der Hinterseite 26 der beiden Mittelquerschienen 16, 20 aufsteckbar.

Bei dem in Figur 1 dargestellten Beispiel weisen beide rückseitig aufeinander liegenden horizontalen Mittelquerschienen 16, 20 auf der von der Frontseite 25 des Baugruppenträgers abgewandten Innenseite 26 je eine längsverlaufende Montagekante 23, 22 auf, welche sich unterhalb der Reihe 17 der Haltelöcher befindet. Im dargestellten Beispiel ist die Kontaktfederleiste 1 unter zu Hilfenahme von deren Klemmbereich 4 auf die längs verlaufende Montagekante 23 der oberen Mittelquerschiene 16 aufgesteckt. Auf der einen Seite der Montagekante 23 liegt somit die Halteleiste 24 der Kontaktfederleiste und auf deren anderen Seite deren Klemmblätter 3 auf. Bei einer anderen, nicht dargestellten Ausführung kann die Kontaktfederleiste 1 auch an der unteren Mittelquerschiene aufgesteckt sein. Es ist wesentlich, daß die von der Kontaktfederleiste 1 abgehenden langgestreckten Kontaktzungen bis in den Spalt 19 hineinreichen und dort beide Mittelquerschienen kontaktieren.

Gemäß der Darstellung im Beispiel der Figur 2 sind bei der Kontaktfederleiste 1 entlang der durchgehenden Halteleiste 24 vorteilhaft abwechselnd die langgestreckten Kontaktzungen 2 nach der einen Seite abgespreizt und die klammerartigen Klemmblätter 3 nach der anderen Seite abgebogen. Hierdurch kann einerseits eine gute Klemmwirkung im Klemmbereich 4 und anderseits eine weiche Federcharakteristik der Kontaktzungen 2 erreicht werden. Mittels u-förmiger Freistanzungen 6 zwischen den Kontaktzungen 2 und den Kopfbereichen 5 in den Übergängen zu den Klemmblättern kann die Weichheit der Federcharakteristik der Kontaktzungen 2 weiter verbessert werden. Vorteilhaft sind die Kontaktzungen 2 um einen Winkel von der Halteleiste 24 abgebogen, welcher größer als 90 Grad ist. In der Darstellung der Figur 2 stehen die Federzungen 2 somit geringfügig nach oben. Die Federzungen reichen gemäß der Darstellung in Figur 1 somit leicht schräg in den Spalt 19 zwischen den beiden Mittelquerschienen hinein und werden leicht gebogen. Hiermit kann eine gute Kontaktierung von beiden Innenflächen der Mittelquerschienen bei optimaler Ausnutzung der Federcharakteristik der Kontaktzungen erreicht werden. Schließlich können vorteilhaft an den Stirnseiten der Kontaktzungen 2 Kontaktecken 7 federartig abgespreizt sein. Auch hierdurch kann die Kontaktierung im Spalt 19 verbessert werden.

## Patentansprüche

1. Baugruppenträger mit mindestens zwei rückseitig aufeinander liegenden Mittelquerschienen (16,20), welche im Bereich von dessen Front- und/oder Rückseite (25) angeordnet sind,
**gekennzeichnet durch**
eine Kontaktfederleiste (1), welche auf der von der Front- bzw. Rückseite (25) des Baugruppenträgers abgewandten Innenseite (26) einer der beiden Mittelquerschienen (16,20) angebracht ist, und langgestreckte, abgespreizte Kontaktzungen (2) aufweist, welche bis in den Spalt (19) zwischen den aufeinander liegenden Rücken der beiden Mittelquerschienen (16,20) reichen.

2. Baugruppenträger nach Anspruch 1, wobei an den Stirnseiten der Kontaktzungen (2) Kontaktecken (7) federartig abgespreizt sind.

3. Baugruppenträger nach Anspruch 1 oder 2, wobei
a) zumindest eine der beiden rückseitig aufeinander liegenden Mittelquerschienen (16,20) eine längsverlaufende Montagekante (23,22) auf der von der Front- bzw. Rückseite (25) des Baugruppenträgers abgewandten Innenseite (26) aufweist, und
b) die Kontaktfederleiste (1) eine durchgehende Halteleiste (24) aufweist, von der zum einen die langgestreckten Kontaktzungen (2) abgespreizt sind und zum anderen klammerartige Klemmblätter (3) abgebogen sind, welche mit der durchgehenden Halteleiste (24) einen Klemmbereich (4) bildend auf die längs verlaufende Montagekante (23,22) von einer der beiden Mittelquerschienen (16,20) aufsteckbar sind.

4. Baugruppenträger nach Anspruch 3, wobei entlang der durchgehenden Halteleiste (24) abwechselnd langgestreckte Kontaktzungen (2) nach der einen Seite abgespreizt und klammerartige Klemmblätter (3) nach der anderen Seite abgebogen sind.

## Claims

1. Mounting rack having at least two centre transverse rails (16, 20), whose rear faces lie one on top of the other and which are arranged in the region of the front and/or rear side (25) of the mounting rack, characterised by a spring contact strip (1) which is fitted on the inside (26) of one of the two centre transverse rails (16, 20) facing away from the front or rear side (25) of the mounting rack, and has elongated, spread-out contact tongues (2) which extend as far as the gap (19) between the backs of the two centre transverse rails (16, 20) lying one on top of the other.

2. Mounting rack according to claim 1, wherein contact corners (7) are spread out in a spring-like manner on the end faces of the contact tongues (2).

3. Mounting rack according to claim 1 or 2, wherein
a) at least one of the two centre transverse rails (16, 20), whose rear faces lie one on top of the other, has a longitudinally extending mounting edge (23, 22) on the inside (26) facing away from the front or rear side (25) of the mounting rack, and
b) the spring contact strip (1) has a continuous retaining strip (24) from which, on the one hand, the elongated contact tongues (2) are spread out and from which, on the other hand, clip-like clamping blades (3) are bent off, which blades, forming a clamping region (4) with the continuous retaining strip (24), can be plugged onto the longitudinally extending mounting edge (23, 22) of one of the two centre transverse rails (16, 20).

4. Mounting rack according to claim 3, wherein along the continuous retaining strip (24) elongated contact tongues (2) are spread out to the one side, alternating with clip-like clamping blades (3) which are bent off to the other side.

## Revendications

1. Porte-module comportant au moins deux rails (16, 20) transversaux centraux qui se trouvent l'un sur l'autre par leurs faces arrières et qui sont montés dans la zone de la face (25) frontale et/ou arrière du porte-module, caractérisé par une baguette (1) élastique de contact qui est montée sur la face (26) intérieure, éloignée de la face (25) frontale ou arrière du porte-module, de l'un des deux rails (16, 20) transversaux centraux et qui comporte des languettes (2) de contact oblongues, écartées, qui vont jusque dans l'intervalle (19) entre les faces arrières se trouvant l'une sur l'autre des deux rails (16, 20) transversaux centraux.

2. Porte-module suivant la revendication 1, des coins (7) de contact étant écartés élastiquement sur les faces frontales des languettes (2) de contact.

3. Porte-module suivant la revendication 1 ou 2,
a) au moins l'un des deux rails (16, 20) transversaux centraux se trouvant l'un sur l'autre par leurs faces arrières comportant un bord (23, 22) de montage s'étendant longitudinalement sur la face (26) intérieure éloignée de la face (25) frontale et/ou arrière du porte-module,
b) la baguette élastique de contact comportant une baguette (24) de maintien continu dont d'une part sont écartées les languettes (2) de contact oblongues et dont d'autre part sont repliées des lames (3) de serrage du genre de pinces qui, en formant une zone (4) de serrage avec la baguette (24) de maintien continu, peuvent être enfichées sur le bord (23, 22) de montage s'étendant longitudinalement de l'un des deux rails (16, 20) transversaux centraux.

4. Porte-module suivant la revendication 3, des languettes (2) de contact oblongues étant écartées d'un côté alternativement le long de la baguette (24) de maintien continu et des lames (3) de serrage du genre de pinces étant repliées de l'autre côté.
